# EUROPEAN PATENT APPLICATION

(11) **EP 3 852 385 A1**
(43) Date of publication of application: **21.07.2021**
(21) Application number: 19870025.4
(22) Date of filing: 01.10.2019
(51) Int. Cl.: H04R 1/02, H04R 1/28, H05K 5/03, H05K 5/00

(54) **ELECTRONIC DEVICE COMPRISING MICROPHONE COUPLING STRUCTURE**

(30) Priority: 02.10.2018 KR 20180117613
(71) Applicant: Samsung Electronics Co., Ltd., Gyeonggi-do 16677 (KR)
(72) Inventor: KIM, Seonghyeon, Suwon-si Gyeonggi-do 16677 (KR); PARK, Jungbae, Suwon-si Gyeonggi-do 16677 (KR); KANG, Hyosung, Suwon-si Gyeonggi-do 16677 (KR); SEO, Hyowon, Suwon-si Gyeonggi-do 16677 (KR); SUNG, Haewon, Suwon-si Gyeonggi-do 16677 (KR)
(74) Representative: Nederlandsch Octrooibureau
(86) International application number: PCT/KR2019/012808
(87) International publication number: WO 2020/071725

(57) **Abstract**

An electronic device according to an embodiment of the disclosure may include a body including a first face which faces a first direction, a second face which faces a second direction opposite to the first direction, and one or more side faces which face a third direction perpendicular to each of the first and second directions, and a rear case which is coupled along the one side faces and includes one or more microphone coupling structures. The rear case may include a rear case outer part, and a rear case inner part coupled to the rear case outer part through horizontal sliding. The microphone coupling structure may include a microphone acoustic duct constructed at the rear case outer part, a microphone rubber mounting portion constructed at the rear case inner part and inserted to the acoustic duct, and a microphone rubber assembled to the microphone rubber mounting portion and spatially coupled to the acoustic duct.

## Description

### Technical Field

Various embodiments of the disclosure relate to a microphone coupling structure of an electronic device.

### Background Art

A microphone to be mounted to an electronic device may be configured in a structure in which at least one or more microphones are mounted to an outermost periphery of a body. Such a microphone may be configured in a structure in which an external sound is transferred to the microphone by means of a microphone acoustic duct structure as a sound passage.

A microphone coupling structure including the microphone acoustic duct may be a one-piece structure or a two-piece structure. In case of the one-piece microphone coupling structure, the microphone acoustic duct and a microphone rubber are coupled to the microphone by being configured as one piece. The two-piece microphone coupling structure is coupled to the microphone by using the microphone acoustic duct and the microphone rubber.

### Disclosure of Invention

### Technical Problem

However, the one-piece or two-piece microphone coupling structure disposed to the conventional electronic device may have one or more microphone holes disposed to the outermost periphery of the body. As a result, a length of the microphone acoustic duct which is a sound passage between the microphone hole and the microphone may become longer

Since the length of the microphone acoustic duct becomes longer, there may be a Hardware (H/W) problem in that a sound loss increases or noise generation increases. In addition, shrinkage may occur at an exterior face (e.g., an exterior face near a portion where the microphone coupling structure is constructed), which may result in an exterior quality problem in that an exterior of the electronic device is not aesthetically good.

Various embodiments according to the disclosure may provide an electronic device including a microphone coupling structure in consideration of assembly, disassembly, and mass production of a microphone.

Various embodiments according to the disclosure may provide an electronic device including a microphone coupling structure in which quality of an exterior face is improved.

Various embodiments according to the disclosure may provide an electronic device including a microphone coupling structure capable of preventing a damage of an assembled microphone rubber, when rear case inner and outer parts are coupled through horizontally sliding.

Various embodiments according to the disclosure may provide an electronic device including a recyclable microphone coupling structure in which a microphone rubber can be assembled/disassembled so that a microphone can be easily replaced when the microphone is broken.

### Solution to Problem

An electronic device according to an embodiment of the disclosure may include a body including a first face which faces a first direction, a second face which faces a second direction opposite to the first direction, and one or more side faces which face a third direction perpendicular to each of the first and second directions, and a rear case which is coupled along the one side faces and includes one or more microphone coupling structures. The rear case may include a rear case outer part, and a rear case inner part coupled to the rear case outer part through horizontal sliding. The microphone coupling structure may include a microphone acoustic duct constructed at the rear case outer part, a microphone rubber mounting portion constructed at the rear case inner part and inserted to the acoustic duct, and a microphone rubber assembled to the microphone rubber mounting portion and spatially coupled to the acoustic duct.

### Advantageous Effects of Invention

A microphone coupling structure according to an embodiment of the disclosure can be easily assembled/disassembled, and can be recycled.

A microphone coupling structure according to an embodiment of the disclosure prevents an exterior face from shrinkage, thereby improving quality of the exterior face.

A microphone coupling structure according to an embodiment of the disclosure is configured in such a manner that a microphone rubber having a microphone mounted thereon is mounted to a rear case inner part and then is coupled to a rear case outer part through horizontal sliding.

### Brief Description of Drawings

FIG. 1A is a plan view illustrating an electronic device according to various embodiments of the disclosure;
FIG. 1B is a side view illustrating an electronic device according to various embodiments of the disclosure;
FIG. 1C is a bottom view illustrating an electronic device according to various embodiments of the disclosure;
FIG. 2 is a bottom view illustrating an electronic device from which a rear case is separated according to various embodiments of the disclosure;
FIG. 3A is a plan view illustrating a rear case according to various embodiments of the disclosure;
FIG. 3B is a bottom view illustrating a rear case according to various embodiments of the disclosure;
FIG. 4A is a plan view illustrating a rear case according to various embodiments of the disclosure;
FIG. 4B is a bottom view illustrating a rear case according to various embodiments of the disclosure;
FIG. 5A is a cross-sectional view illustrating a microphone coupling structure of an electronic device according to various embodiments of the disclosure;
FIG. 5B is a cutaway perspective view illustrating a microphone coupling structure of an electronic device according to various embodiments of the disclosure;
FIG. 6A is a perspective view illustrating a microphone acoustic duct having a microphone coupling structure according to various embodiments of the disclosure;
FIG. 6B is a cross-sectional view illustrating a microphone acoustic duct having a microphone coupling structure according to various embodiments of the disclosure;
FIGS. 7A, 7B are a perspective view illustrating a microphone rubber mounting portion having a microphone coupling structure according to various embodiments of the disclosure;
FIG. 8A is a perspective view illustrating a microphone rubber having a microphone coupling structure according to various embodiments of the disclosure;
FIG. 8B is a plan view illustrating a microphone rubber having a microphone coupling structure according to various embodiments of the disclosure;
FIG. 8C is a front view illustrating a microphone rubber having a microphone coupling structure according to various embodiments of the disclosure;
FIG. 9 illustrates an example of a state in which a microphone rubber can be assembled and disassembled according to various embodiments of the disclosure;
FIGS. 10A to 10C are a side cross-sectional view illustrating sequentially a process in which a rear case inner part is coupled to a rear case outer part through sliding;
FIG. 11 is a partially enlarged view illustrating a locking structure between a rear case outer part and a rear case inner part according to various embodiments of the disclosure;
FIG. 12A is a plan view illustrating a rear case according to various embodiments of the disclosure;
FIG. 12B is a cross-sectional view taken along the line A-A' of FIG. 12A;
FIG. 12C is a cutaway perspective view illustrating a microphone coupling structure of an electronic device according to various embodiments of the disclosure;
FIG. 13A is a perspective view illustrating a microphone acoustic duct having a microphone coupling structure according to various embodiments of the disclosure;
FIG. 13B is a perspective view illustrating a microphone insert having a microphone coupling structure according to various embodiments of the disclosure;
FIG. 13C is a perspective view illustrating a microphone coupling structure according to various embodiments of the disclosure;
FIG. 14A is a perspective view illustrating a locking structure for preventing a microphone from being lifted according to various embodiments of the disclosure;
FIG. 14B is a perspective view illustrating a locking hole constructed at a microphone mounting portion according to various embodiments of the disclosure;
FIG. 14C is a perspective view illustrating a locking protrusion constructed at a microphone PCB according to various embodiments of the disclosure;
FIG. 15 is a plan view sequentially illustrating a process in which a rear case inner part is coupled to a rear case outer part through sliding according to various embodiments of the disclosure;
FIG. 16A is a plan view illustrating a state in which a microphone is mounted to a microphone coupling structure according to various embodiments of the disclosure;
FIG. 16B is a cross-sectional view taken along the line B-B' of FIG. 12A;
FIG. 16C is a cutaway perspective view illustrating a microphone coupling structure of an electronic device according to various embodiments of the disclosure;
FIG. 17A is a perspective view illustrating a microphone storing portion constructed at a rear case outer part according to various embodiments of the disclosure;
FIG. 17B is a perspective view illustrating an opening to be inserted to a microphone storing portion, which is constructed at a rear case inner part, according to various embodiments of the disclosure;
FIG. 17C is a plan view illustrating a microphone coupling structure according to various embodiments of the disclosure;
FIG. 18 is a cross-sectional view illustrating a rear case outer part according to various embodiments of the disclosure; and
FIG. 19 is a perspective view illustrating a locking structure for preventing a mounted microphone from being lifted according to various embodiments of the disclosure.

### Best Mode for Carrying out the Invention

Hereinafter, various embodiments of the disclosure are described with reference to the accompanying drawings. However, it should be appreciated that this is not intended to limit the technological features set forth herein to particular embodiments and include various changes, equivalents, or replacements for an embodiment of the disclosure. With regard to the description of the drawings, similar reference numerals may be used to refer to similar or related elements.

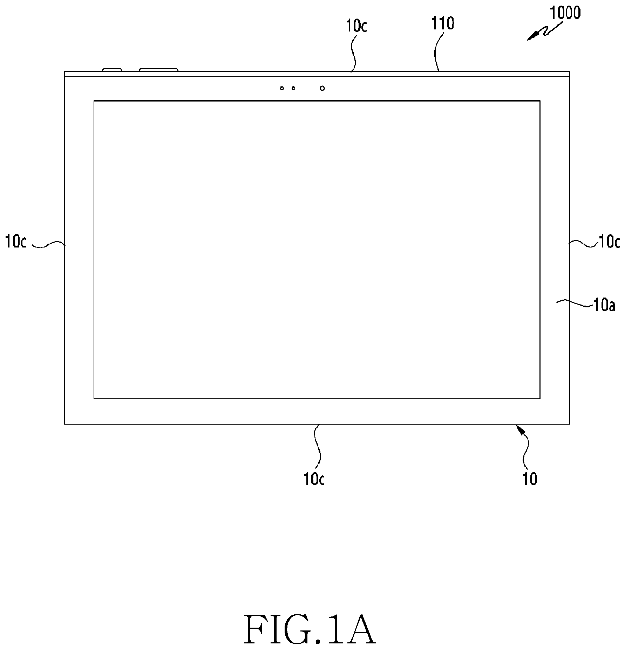

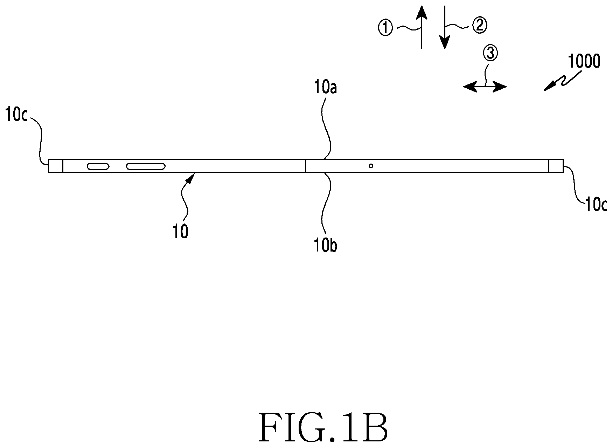

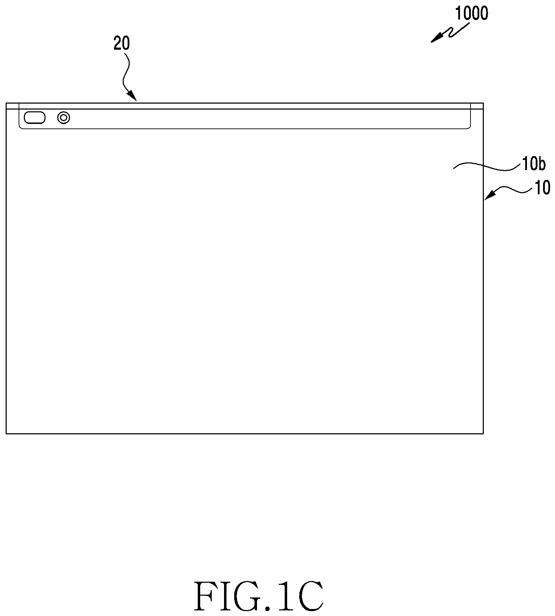

FIG. 1A is a plan view illustrating an electronic device according to various embodiments of the disclosure. FIG. 1B is a side view illustrating an electronic device according to various embodiments of the disclosure. FIG. 1C is a bottom view illustrating an electronic device according to various embodiments of the disclosure.

Referring to FIG. 1A to FIG. 1C, an electronic device 1000 according to various embodiments of the disclosure may include at least one of, for example, a smartphone, a tablet Personal Computer (PC), a mobile phone, a video phone, an e-book reader, a desktop PC, a laptop PC, a netbook computer, a workstation, a server, a Personal Digital Assistant (PDA), a Portable Multimedia Player (PMP), a MPEG-1 Audio Layer 3 (MP3) player, a mobile medical device, a camera, and a wearable device (e.g., smart glasses, a Head-Mounted Display (HMD), electronic clothes, an electronic bracelet, an electronic necklace, an electronic appcessory, an electronic tattoo, a smart mirror, or a smart watch).

The electronic device 1000 according to various embodiments may include one body 10. As a case which protects electronic components, the body 10 according to various embodiments may include a first face 10a facing a first direction ①, a second face 10b facing a second direction ② opposite to the first direction ①, and at least one or more side faces 10c facing a third direction ③ facing a direction perpendicular to each of the first and second directions ① and ②. For example, a display device 110 may be disposed to the first face 10a of the electronic device 1000, a camera or the like may be disposed to the second face 10b, and at least one or more keys (not shown) may be disposed to the side face 10c. For example, the electronic device 1000 may include four side faces 10c. Among the four side faces 10c, a rear case 20 may be coupled to the side face 10c located in the back.

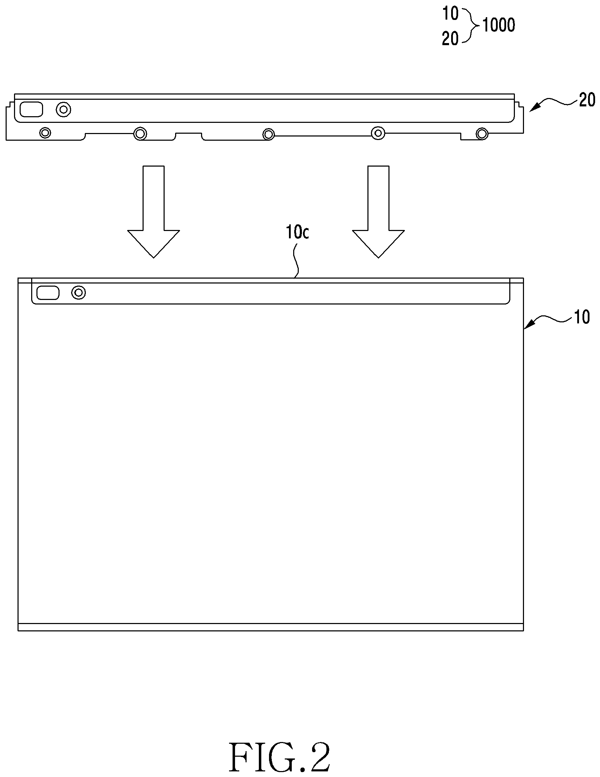

FIG. 2 is a bottom view illustrating an electronic device from which a rear case is separated according to various embodiments of the disclosure.

Referring to FIG. 2, an electronic device 1000 according to various embodiments may include a body 10 and a rear case 20 coupled to one side face 10c of the body 10. For example, at least one or more antenna radiators (not shown) and at least one or more acoustic components, for example, at least one or more microphones (not shown), may be mounted to the rear case 20.

The rear case 20 according to various embodiments may be additionally assembled and thus coupled to the side face 10c of the body 10. For example, the rear case 20 may have at least one or more antenna radiators mounted thereon to function as a housing for securing antenna performance, and may be disposed outside the body 10 to function as a decoration related to an exterior of the electronic device 1000.

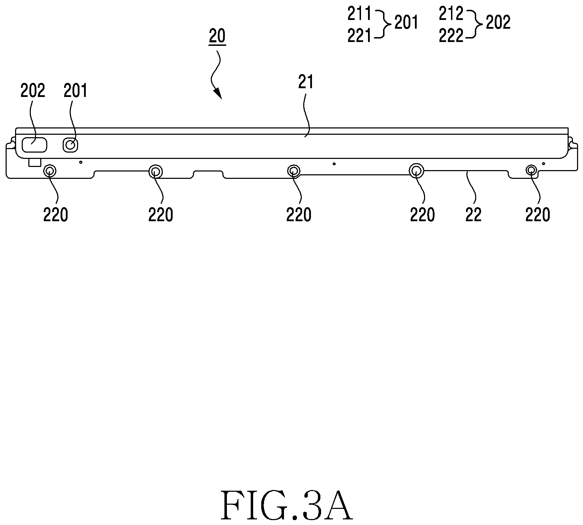

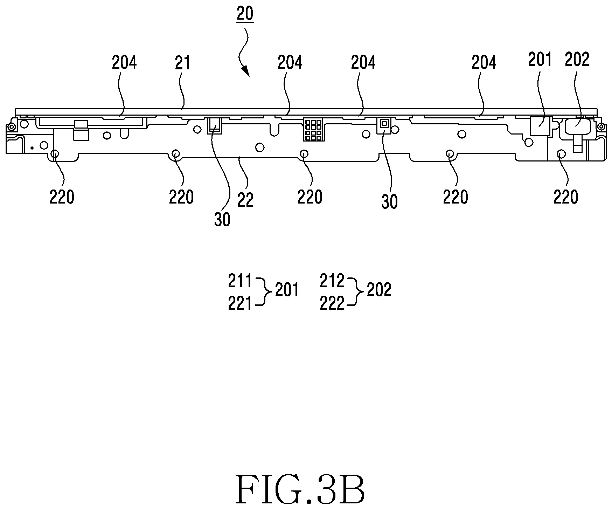

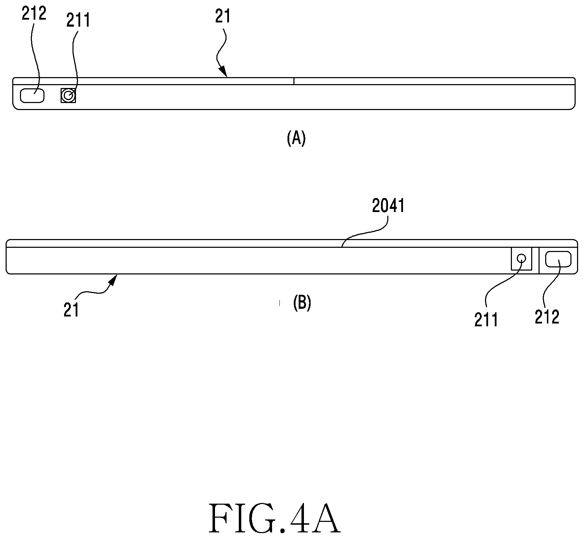

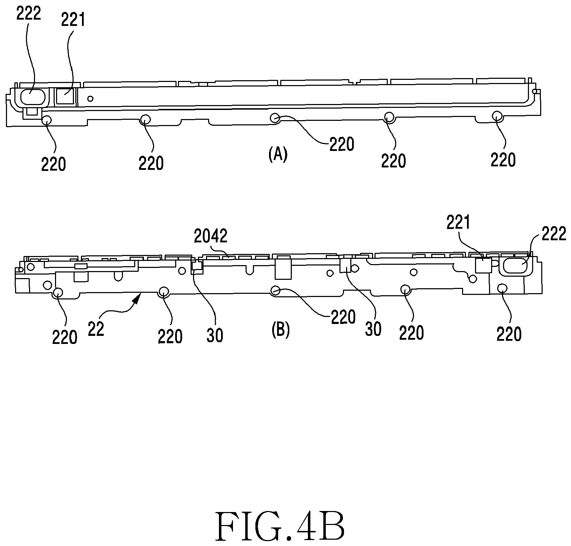

FIG. 3A is a plan view illustrating a rear case according to various embodiments of the disclosure. FIG. 3B is a bottom view illustrating a rear case according to various embodiments of the disclosure. FIG. 4A is a plan view illustrating a rear case according to various embodiments of the disclosure. FIG. 4B is a bottom view illustrating a rear case according to various embodiments of the disclosure.

Referring to FIG. 3A to FIG. 4B, a rear case 20 according to various embodiments may include a rear case outer part 21 and a rear case inner part 22. The rear case outer part 21 coupled to the rear case inner part 22 may be visible as part of an exterior of a body (e.g., the body 10 of FIG. 1), and the rear case inner part 22 coupled to the body may be invisible as part of the exterior. The rear case inner part 22 may be coupled to the rear case outer part 21 by means of a plurality of locking structures 204 through a sliding motion. For example, the locking structure 204 may be constructed by combining a locking hole and a locking protrusion. The plurality of locking structures 204 may be constructed along a lengthwise direction of the rear case 20.

The rear case 20 according to various embodiments may be constructed of a plastic material, and various colors may be used to perform a function for improving quality of an exterior of an electronic device 1000.

The rear case inner part 22 according to various embodiments may be attached to the rear case outer part 21 through bonding. A portion attached with bonding is a gap between faces facing a bottom portion of the rear case outer part 21 and a bottom portion of the rear case inner part 22. A liquid adhesive solution may be coated between the faces facing each other to proceed a coupling process based on a sliding movement of the rear case outer part 21 and the rear case inner part 22.

For example, the rear case inner part 22 may have a plurality of fastening holes 220 constructed in a lengthwise direction. The fastening hole 220 may be part of a fastening structure for coupling a body (e.g., the body 10 of FIG. 2) by using a fastener (not shown). The rear case 20 according to various embodiments may have at least one or more openings 201 and 202 constructed thereon. For example, the at least one or more openings may be the opening 201 for a camera lens or the opening 202 for a sensor. The sensor may include a proximity sensor, an optical sensor, or the like. The opening 201 for the camera lens may include an opening 211 constructed at the rear case outer part 21 and an opening 221 constructed at the rear case inner part 22. The opening 202 for the sensor may include an opening 212 constructed at the rear case outer part 21 and an opening 222 constructed at the rear case inner part 22.

The rear case 20 according to various embodiments may include at least one or more microphone coupling structures 30. The microphone coupling structure 30 may have a microphone mounted thereon, and may provide a sound passage of the microphone.

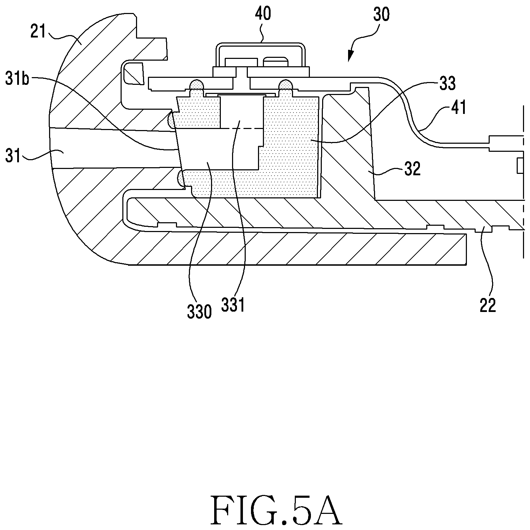

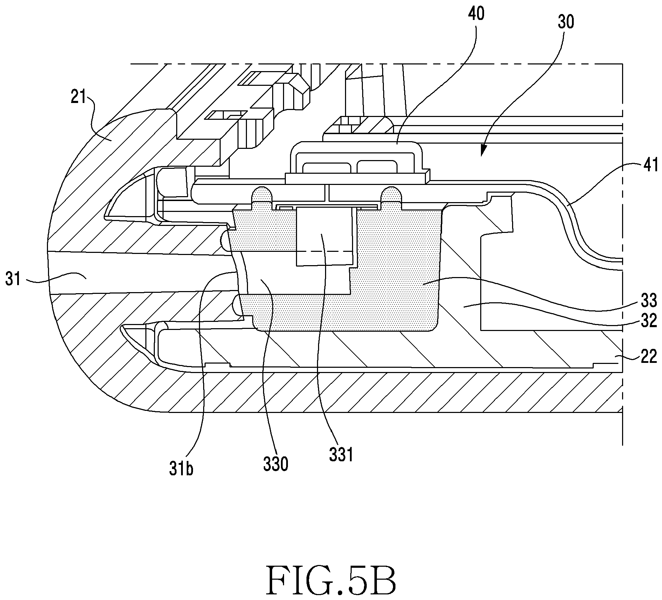

FIG. 5A is a cross-sectional view illustrating a microphone coupling structure of an electronic device according to various embodiments of the disclosure. FIG. 5B is a cutaway perspective view illustrating a microphone coupling structure of an electronic device according to various embodiments of the disclosure.

Referring to FIG. 5A and FIG. 5B, a microphone coupling structure 30 according to various embodiments may include a microphone acoustic duct 31, a microphone rubber mounting portion 32, and a microphone rubber 33.

The microphone acoustic duct 31 according to various embodiments may be constructed at a rear case outer part 21, and may be a sound passage for transferring an external sound to a microphone 40. The microphone rubber mounting portion 32 may be constructed at a rear case inner part 22, and may be a portion to which the microphone rubber 33 is mounted. The microphone rubber 33 is a component for mounting the microphone 40 to the microphone rubber mounting portion 32, and may be mounted to the microphone rubber mounting portion 32 by vertically moving in a downward direction. The microphone rubber 33 may be constructed of an elastic material, and thus an outer face thereof may be tightly in contact with the microphone rubber mounting portion 32. A reference numeral 41 may be a Flexible Printed Circuit Board (FPCB) for electrically coupling the microphone 40 to a main PCB (not shown).

The microphone rubber 33 according to various embodiments may include first and second sound passages 330 and 331. The first sound passage 330 may be spatially coupled with the other end 31b of the microphone acoustic duct 31. The first sound passage 330 may extend in a third direction (e.g., the third direction ③ of FIG. 1B). The second sound passage 331 may be spatially coupled with the first sound passage 330, and may be spatially coupled with the microphone 40. The second sound passage 331 may extend in a first direction (e.g., the third direction ① of FIG. 1B). A sound transferred through the microphone acoustic duct 31 may arrive at the microphone 40 via the first and second sound passages 330 and 331.

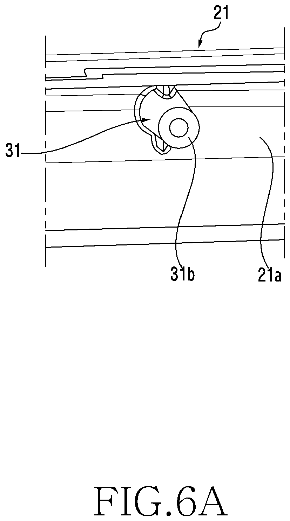

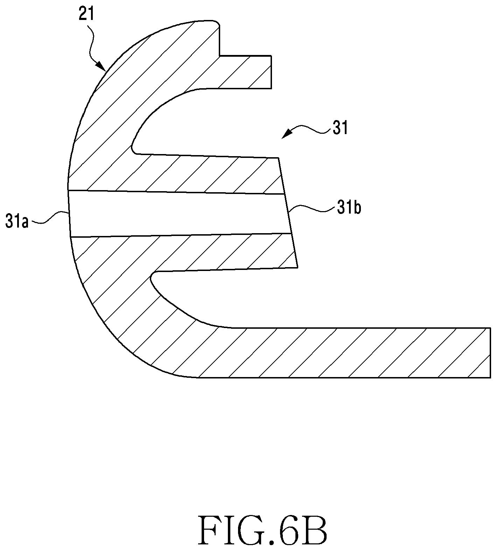

FIG. 6A is a perspective view illustrating a microphone acoustic duct having a microphone coupling structure according to various embodiments of the disclosure. FIG. 6B is a cross-sectional view illustrating a microphone acoustic duct having a microphone coupling structure according to various embodiments of the disclosure.

Referring to FIG. 6A and FIG. 6B, a microphone acoustic duct 31 according to various embodiments may protrude towards a microphone rubber (e.g., the microphone rubber 33 of FIG. 5A) on an inner face 21a of a rear case outer part 21. For example, the microphone acoustic duct 31 may be injection-molded integrally on the inner face of the rear case outer part 21.

The microphone acoustic duct 31 according to various embodiments may include one end 31a and the other end 31b. The one end 31a may be part of an exterior of the rear case outer part 21, for example, a microphone hole, and the other end 31b may be a portion closely in contact with the microphone rubber (e.g., the microphone rubber 33 of FIG. 5A). A space between the one end 31a and the other end 31b may be a sound transfer passage through which a sound passes. According to an embodiment, the other end 31b may be constructed as an inclined face so that the microphone rubber (e.g., the microphone rubber 33 of FIG. 5A) can be easily assembled and disassembled.

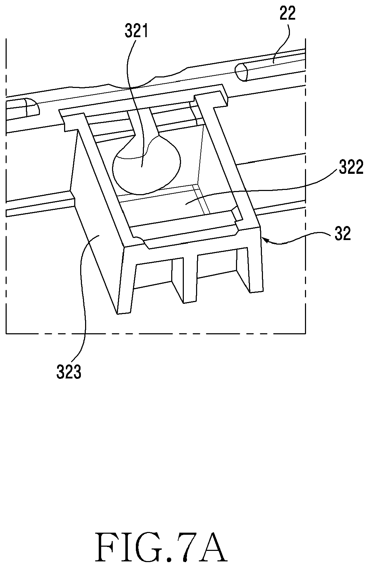

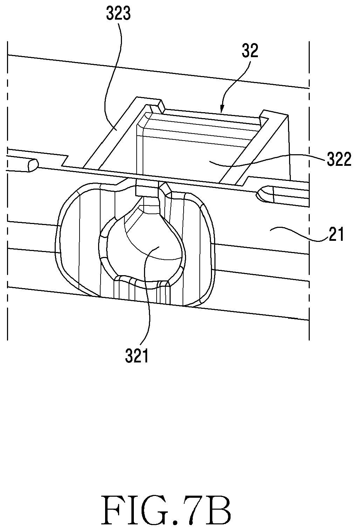

FIG. 7A and FIG. 7B are perspective views illustrating a microphone rubber mounting portion having a microphone coupling structure according to various embodiments of the disclosure.

Referring to FIG. 7A and FIG. 7B, a microphone rubber mounting portion 32 according to various embodiments may be constructed integrally at a rear case inner part 22. According to an embodiment, the microphone rubber mounting portion 32 may include first and second openings 321 and 322 and a plurality of side walls 323.

The first opening 321 according to various embodiments may be open in a third direction (e.g., the third direction ③ of FIG. 1B), and a microphone acoustic duct (e.g., the microphone acoustic duct 31 of FIG. 6A) may penetrate through it. The second opening 322 according to various embodiments may be open in a first direction (e.g., the first direction ① of FIG. 1B) in which the microphone rubber (e.g., the microphone rubber 33 of FIG. 5) is inserted. The plurality of side walls 323 according to various embodiments may have a shape protruding in the first direction (e.g., the first direction ① of FIG. 1B), which surrounds the first and second openings 321 and 322. The second opening 322 may be a mounting space to which a microphone rubber 33 is mounted, and the side walls 323 may be a support structure which supports the mounted microphone rubber 33.

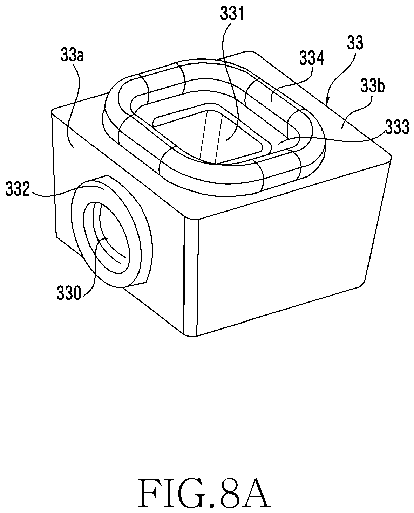

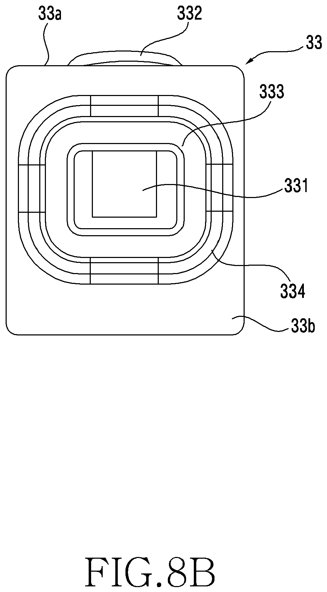

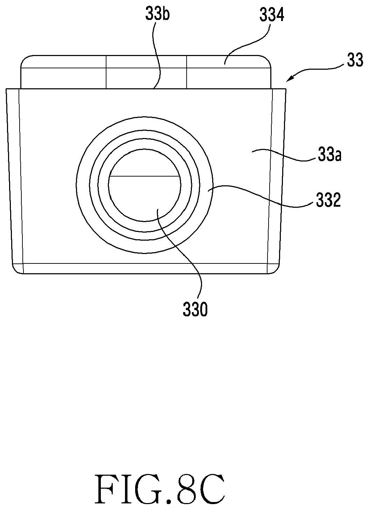

FIG. 8A is a perspective view illustrating a microphone rubber having a microphone coupling structure according to various embodiments of the disclosure. FIG. 8B is a plan view illustrating a microphone rubber having a microphone coupling structure according to various embodiments of the disclosure. FIG. 8C is a front view illustrating a microphone rubber having a microphone coupling structure according to various embodiments of the disclosure.

Referring to FIG. 8A to FIG. 8C, a microphone rubber 33 according to various embodiments may be a mounting member used to assemble a microphone (e.g., the microphone 40 of FIG. 5A) to a microphone mounting portion (e.g., the microphone rubber mounting portion 32 of FIG. 7A). According to an embodiment, the microphone rubber 33 may include first and second sound passages 330 and 331 (e.g., the first and second sound passages 330 and 331 of FIG. 5A).

The microphone rubber 33 according to various embodiments may further include a first protrusion 332 for preventing a sound leakage to seal between the other end (e.g., the other end 31b of FIG. 6B) of a microphone acoustic duct (e.g., the microphone acoustic duct 31 of FIG. 5A) and one end of the first sound passage 330 (e.g., the first sound passage 330 of FIG. 5A). For example, the first protrusion 332 for preventing the sound leakage may be constructed at a first face 33a of the microphone rubber 33, and may be closely in contact, as a ring shape, with the other end (e.g., the other end 31b of FIG. 6B) of the microphone duct 31. According to an embodiment, the first face 33a may be a side face facing a microphone acoustic duct (e.g., the microphone acoustic duct 31 of FIG. 6A). The first protrusion 332 for preventing the sound leakage may be a portion to be compressed by being closely in contact with the microphone acoustic duct (e.g., the microphone acoustic duct 31 of FIG. 5A).

The microphone rubber 33 according to various embodiments may further include a seating portion 333 to which a microphone (e.g., the microphone 40 of FIG. 5A) is mounted. The seating portion 333 may be disposed to a second face 33b of the microphone rubber 33. For example, the second face 33b may be an upper face of the microphone rubber 33. The mounting portion 333 according to various embodiments may further include a second protrusion 334 for preventing a sound leakage, in order to prevent the sound leakage of the mounted microphone. The second protrusion 334 for preventing the sound leakage may extend in a closed-loop shape along a periphery of a mounted microphone (e.g., the microphone 40 of FIG. 5A). For example, the second protrusion 334 for preventing the sound leakage may protrude in a first direction (e.g., the first direction ① of FIG. 1B). The microphone rubber 33 may be manufactured as a single entity, and may be mounted to a microphone mounting portion (e.g., the microphone rubber mounting portion 32 of FIG. 7A) after the microphone is assembled.

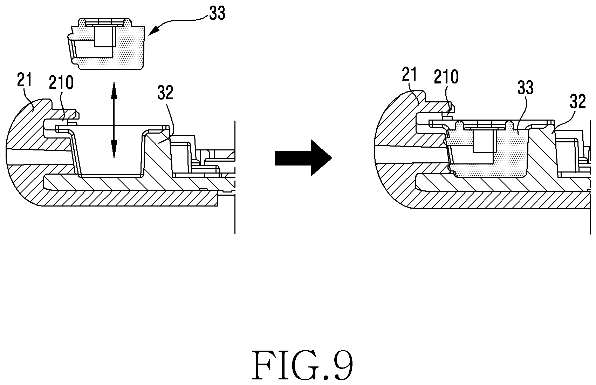

FIG. 9 illustrates an example of a state in which a microphone rubber can be assembled and disassembled according to various embodiments of the disclosure.

Referring to FIG. 9, a microphone coupling structure (e.g., the microphone coupling structure 30 of FIG. 5A) according to various embodiments may be constructed such that a microphone rubber 33 is assembled to a microphone rubber mounting portion 32 or the assembled microphone rubber 33 is detachable from the microphone rubber mounting portion 32. The assembled microphone rubber 33 may be assembled by being pushed to the microphone rubber mounting portion 32 vertically in a downward direction. The microphone rubber 33 may be detached from the microphone rubber mounting portion 32 by being pulled vertically in an upward direction.

According to a detachable structure of the microphone rubber 33, when a microphone (e.g., the microphone 40 of FIG. 5A) is broken, a new microphone rubber can be assembled and used after the microphone rubber 33 is detached. A direction of detaching the microphone rubber 33 may be a substantially vertical movement direction.

The microphone coupling structure (e.g., the microphone coupling structure 30 of FIG. 5A) according to various embodiments may further include a locking structure 210 for preventing the microphone rubber 33 mounted to a rear case outer part 21 from being lifted. The locking structure 210 may extend in a horizontal direction from an upper end of the rear case outer part 21 in such a manner that it is partially located on the mounted microphone rubber 33. A portion of the mounted microphone rubber 33 may be prevented from being lifted at the microphone rubber mounting portion 32 due to the locking structure 210.

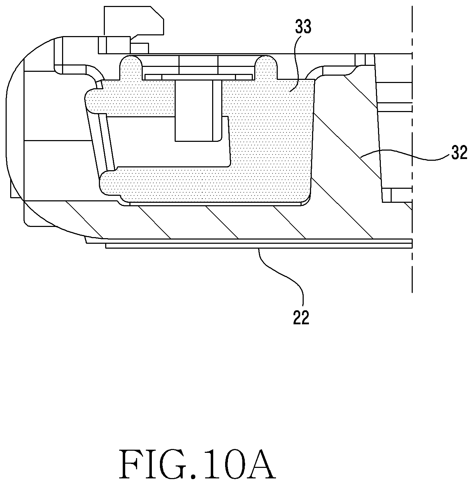

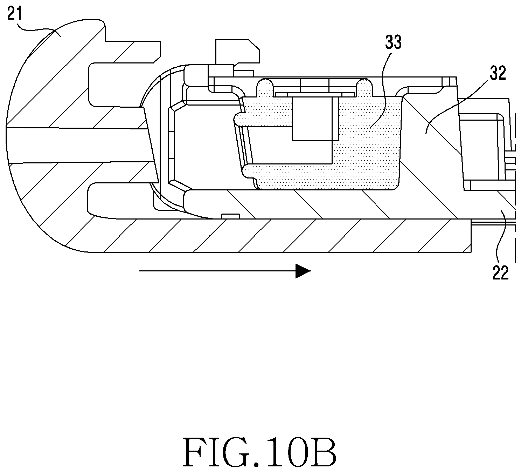

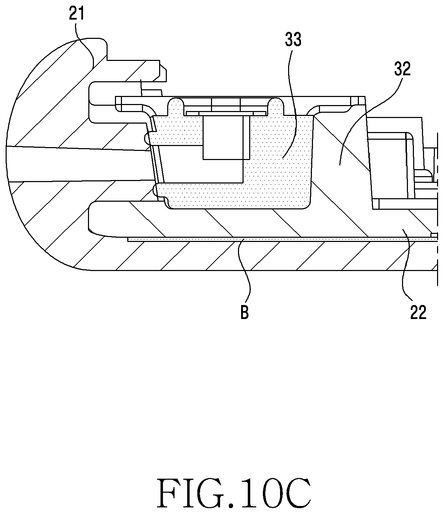

FIG. 10A to FIG. 10C are side cross-sectional views illustrating sequentially a process in which a rear case inner part is coupled to a rear case outer part through sliding. A method of mounting a microphone will be described below with reference to FIG. 10A to FIG. 10C.

A microphone rubber 33 may be assembled to a microphone rubber mounting portion 32. Subsequently, a rear case inner part 22 to which the microphone rubber 33 is assembled may be coupled to a rear case outer part 21 through horizontal sliding. Due to a sliding movement of the rear case outer part 21, the rear case outer part 21 and the rear case inner part 22 may be assembled as a single body due to a locking structure (e.g., the locking structure 204 of FIG. 3B). When the rear case outer part 21 and the rear case inner part 22 are coupled, an adhesive solution may be applied between one face of a bottom portion of the rear case inner part 22 and one face of a bottom portion of the rear case outer part 21 so that they are adhered to each other. A reference numeral B may indicate an adhesive layer.

When the rear case inner part 22 is assembled to the rear case outer part 21, audible clicking occurs in a last step, thereby constructing a locking structure. The locking structure may be constructed by inserting a locking protrusion to a locking hole.

Compared to the conventional technique, a microphone assembly structure according to an embodiment allows a microphone to be able to be mounted by a simple horizontal sliding movement, thereby preventing the microphone rubber 33 to be mounted to the rear case inner part 22 from being damaged, e.g., being chewed up.

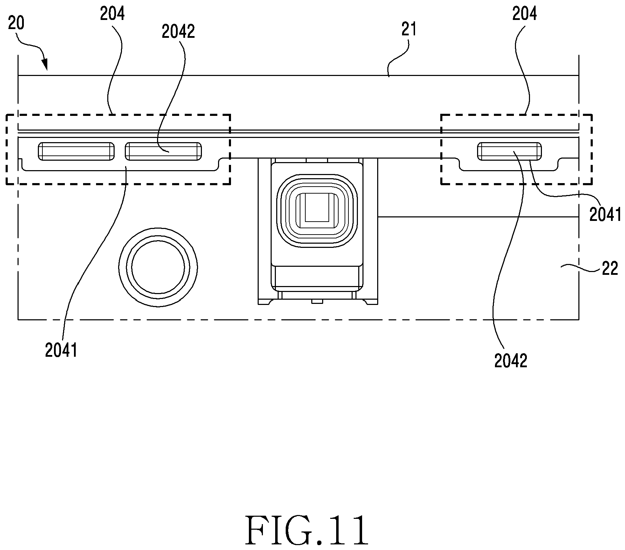

FIG. 11 is a partially enlarged view illustrating a locking structure between a rear case outer part and a rear case inner part according to various embodiments of the disclosure.

Referring to FIG. 11, a locking structure 204 according to various embodiments may include a locking hole 2041 and a locking protrusion 2042. For example, the locking hole 2041 may be constructed at a rear case outer part 21, and the locking protrusion 2042 may be constructed at a rear case inner part 22. However, without being limited thereto, the locking hole 2041 may be constructed at the rear case inner part 22, and the locking protrusion 2042 may be constructed at the rear case outer part 21. For example, as another embodiment of the locking structure 204, a coupling structure using a hook and a locking recess may be applied. For example, each of the locking hole 2041 and the locking protrusion 2042 may have an elongated shape extending vertically in a sliding direction.

The locking structure 204 according to various embodiments may be constructed according to a horizontal sliding movement of the rear case inner part 22 or the rear case outer part 21 (e.g., the sliding movement of the rear case inner part or outer part of FIG. 10A to FIG. 10C).

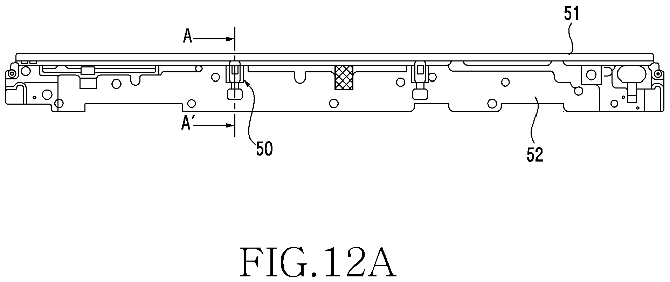

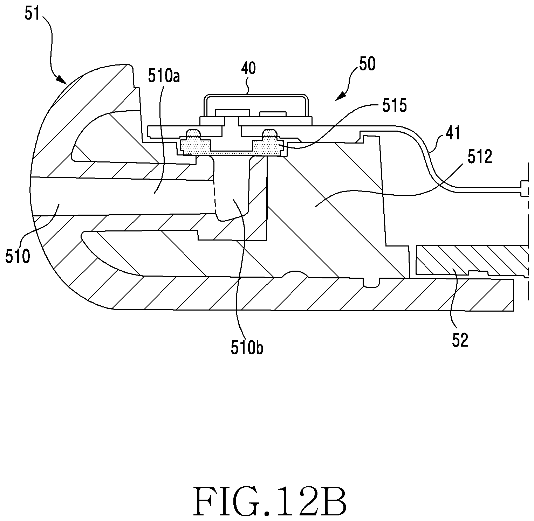

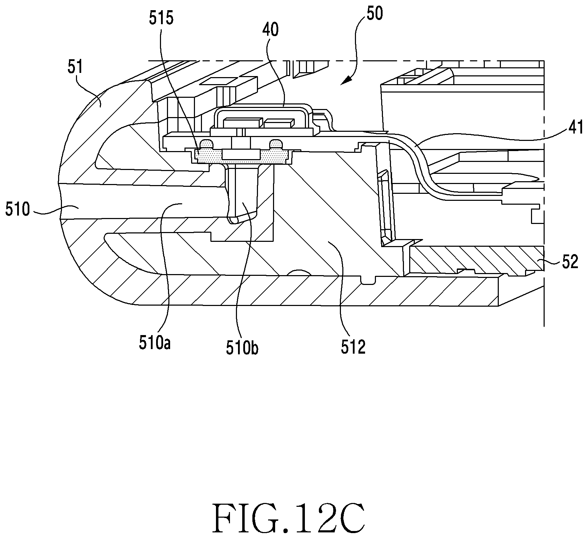

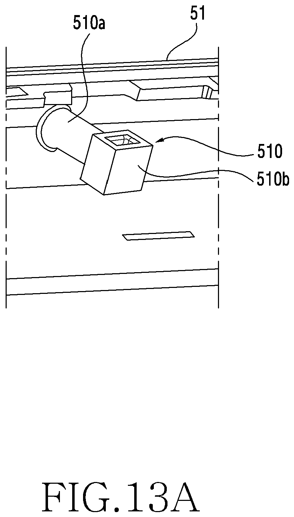

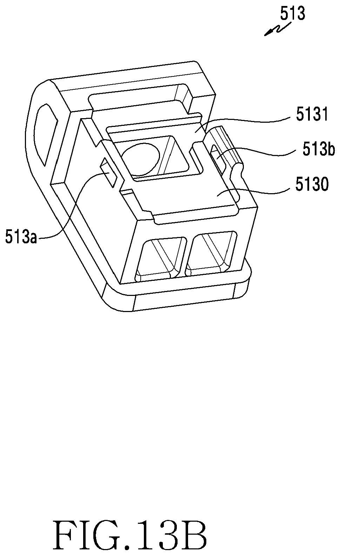

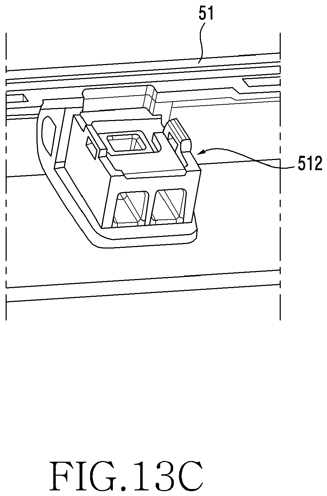

FIG. 12A is a plan view illustrating a rear case according to various embodiments of the disclosure. FIG. 12B is a cross-sectional view taken along the line A-A' of FIG. 12A. FIG. 12C is a cutaway perspective view illustrating a microphone coupling structure of an electronic device according to various embodiments of the disclosure. FIG. 13A is a perspective view illustrating a microphone acoustic duct having a microphone coupling structure according to various embodiments of the disclosure. FIG. 13B is a perspective view illustrating a microphone insert having a microphone coupling structure according to various embodiments of the disclosure. FIG. 13C is a perspective view illustrating a microphone coupling structure according to various embodiments of the disclosure.

Referring to FIG. 12A to FIG. 13C, a microphone coupling structure 50 (e.g., the microphone coupling structure 30 of FIG. 5A) according to various embodiments may include a microphone acoustic duct 510 and a microphone mounting portion 512. The microphone acoustic duct 510 according to various embodiments may be constructed integrally at a rear case outer part 51 through an injection process.

The microphone mounting portion 512 according to various embodiments may be constructed through a double-injection process by using a microphone insert (e.g., the microphone insert 513 of FIG. 13B). The microphone mounting portion 512 may be constructed at the rear case outer part 51 by being double-injected in a state of being assembled with the microphone insert, and may be constructed integrally with respect to the microphone acoustic duct 510 so that a prepared microphone 40 is mounted thereon.

A structure of the microphone acoustic duct 510 according to various embodiments may include a first sound passage 510a extending in a substantially horizontal direction and a second sound passage 510b extending in a substantially vertical direction. The first and second sound passages 510a and 510b may be spatially coupled integrally. One end of the microphone acoustic duct 510 may be the rear case outer part 51, and the other end may face the microphone 40.

The microphone insert 513 according to various embodiments may be manufactured separately, and may be constructed through a double-injection process while being inserted to the microphone acoustic duct 510. The microphone insert 513 may have locking holes 513a and 513b constructed at an upper face facing a second direction (e.g., a second direction ② of FIG. 1B). For example, the locking holes 513a and 513b may be constructed symmetrically as a pair at an upper face of the microphone insert 513. A second sound passage (e.g., the second sound passage 510b of FIG. 12B) may be located between the pair of locking holes 513a and 513b. A seating groove 5131 to which a sealing member 515 for sealing the microphone 40 is seated may be constructed at an upper face 5130 of the microphone insert 513. The sealing member (e.g., the sealing member 515 of FIG. 12B) may be used to seal between the microphone 40 and the microphone mounting portion 512 according to various embodiments. For example, the sealing member 515 may be constructed of an elastic rubber material or a silicon material. The sealing member 515 according to various embodiments may further have a protrusion for preventing a sound leakage. The protrusion for preventing the sound leakage may protrude in a direction of the microphone 40.

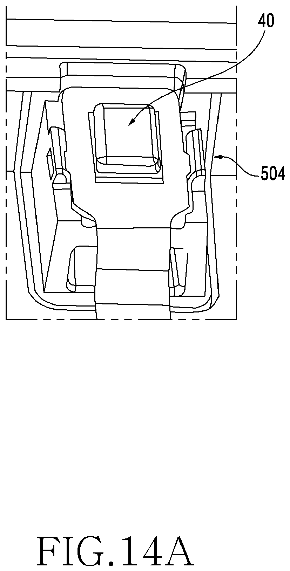

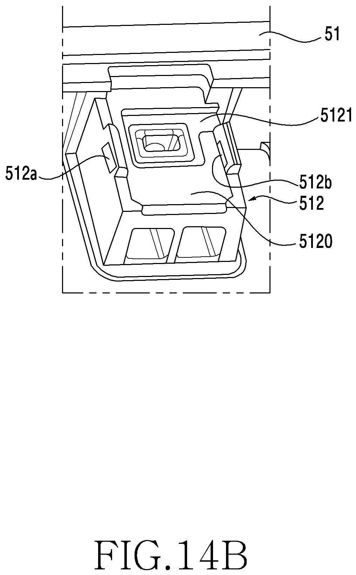

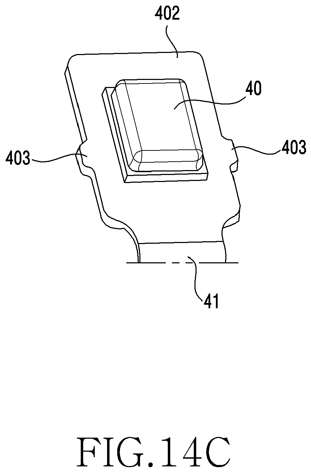

FIG. 14A is a perspective view illustrating a locking structure for preventing a microphone from being lifted according to various embodiments of the disclosure. FIG. 14B is a perspective view illustrating a locking hole constructed at a microphone mounting portion according to various embodiments of the disclosure. FIG. 14C is a perspective view illustrating a locking protrusion constructed at a microphone PCB according to various embodiments of the disclosure.

Referring to FIG. 14A to FIG. 14C, a locking structure 504 according to various embodiments which prevents a mounted microphone 40 from being lifted may be constructed by coupling a pair of locking protrusions 403 and a pair of locking holes 512a and 512b. For example, the pair of locking holes 512a and 512b may be constructed at an upper face of the microphone mounting portion 512, and the pair of locking protrusions 403 may be constructed at a rigid PCB 402 of the microphone 40. The microphone 40 may include the rigid PCB 402 and a flexible PCB 41 electrically coupled to part of the PCB 402. One end of the flexible PCB 41 may have a slim connector so as to be coupled to a main PCB (not shown).

The pair of locking holes 512a and 512b according to various embodiments may be constructed integrally at the microphone mounting portion 512, and each of the holes may be constructed in a shape which is open in a third direction (e.g., the third direction ③ of FIG. 1B). The pair of locking protrusions 403 according to various embodiments may be constructed integrally at the PCB 402, and each of the locking protrusions 403 may be constructed in a shape which protrudes in the third direction (e.g., the third direction ③ of FIG. 1B). The locking protrusions 403 may protrude in directions away from each other. The locking protrusions 403 may be inserted respectively to the locking holes 512a and 512b, and thus the mounted microphone 40 may be seated to the microphone mounting portion 512 in a state of being sealed. The microphone mounting portion 512 may include a microphone seating portion 5121 at an upper face 5120. The microphone seating portion 5121 may be constructed in a recessed structure.

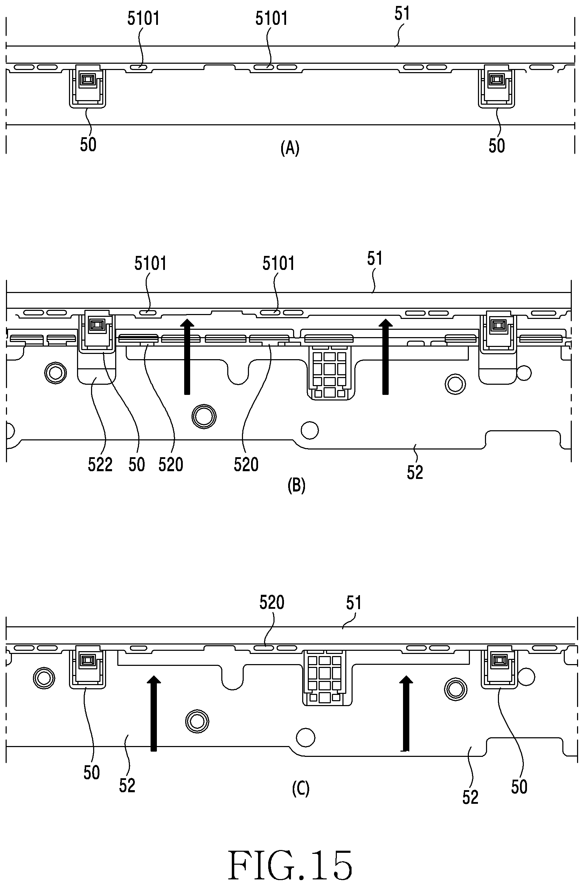

FIG. 15 is a plan view sequentially illustrating a process in which a rear case inner part is coupled to a rear case outer part through sliding according to various embodiments of the disclosure.

Referring to FIG. 15, a rear case according to various embodiments may be coupled by sliding a rear case inner part 52 to a rear case outer part 51. For example, the sliding movement may be a substantially horizontal movement.

The rear case outer part 51 according to various embodiments may have at least one or more locking holes 5101 constructed along a lengthwise direction. The locking hole 5101 may be constructed between microphone coupling structures 50. For example, each of the locking holes 1501 may have a vertically long shape in a sliding direction.

The rear case inner part 52 according to various embodiments may have at least one or more locking protrusions 520 constructed along the lengthwise direction. The locking protrusion 520 may be constructed between openings 522 to which the microphone coupling structures 50 are inserted. For example, each of the locking holes 520 may have a vertically long shape in the sliding direction. The coupling between the rear case outer part 51 and the rear case inner part 52 may be achieved in such a manner that one side is coupled by means of a locking structure. In the coupling, an adhesive solution or the like may be used for bonding. The locking structure may be disposed between the microphone coupling structures 50.

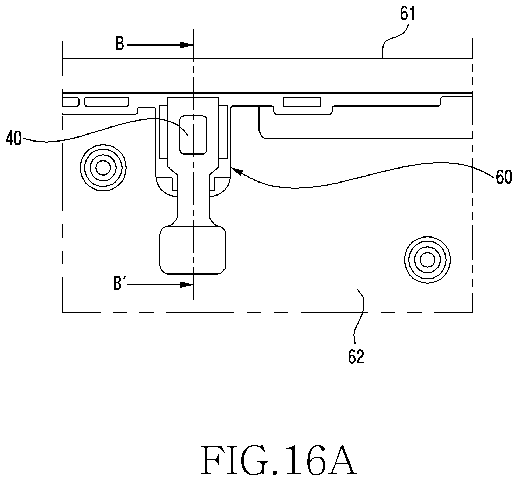

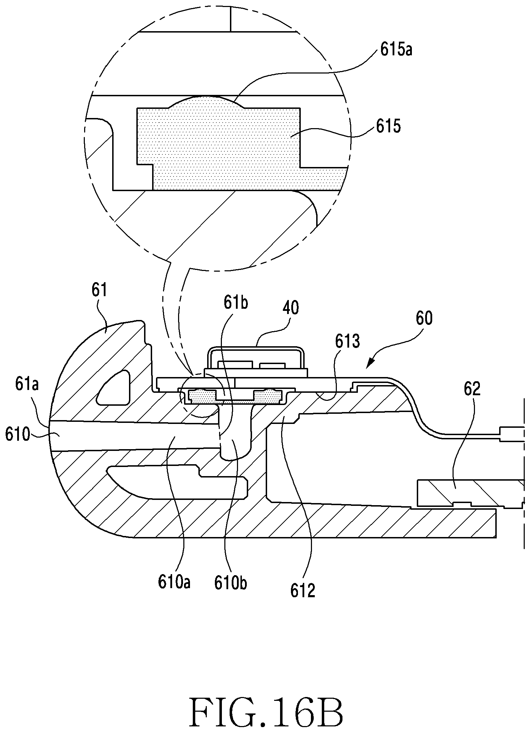

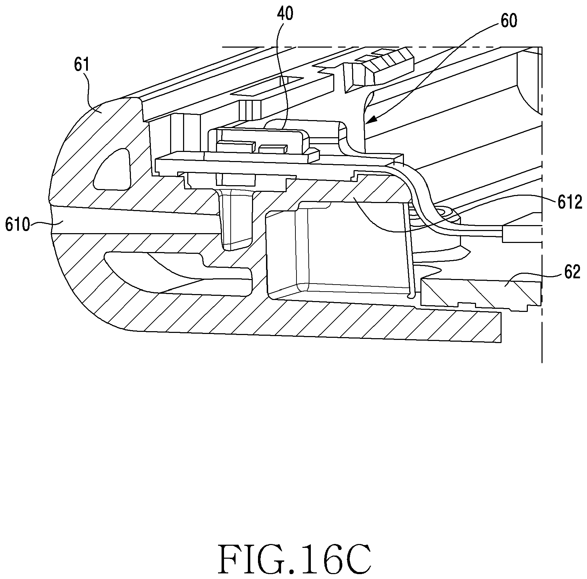

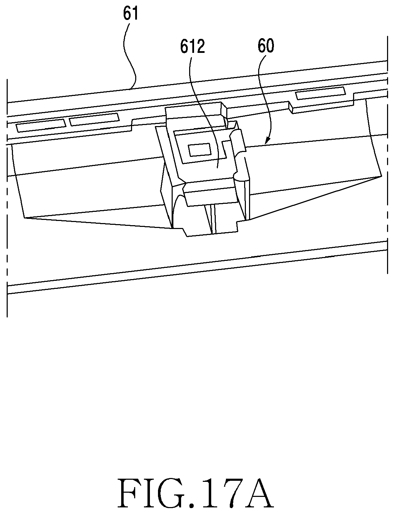

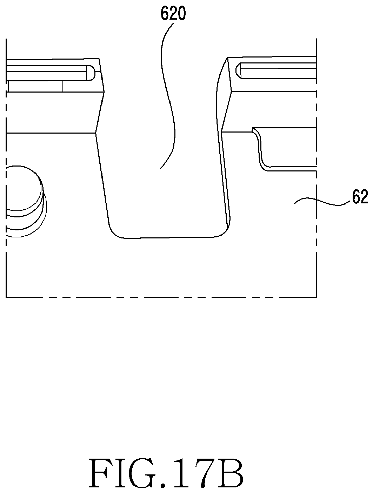

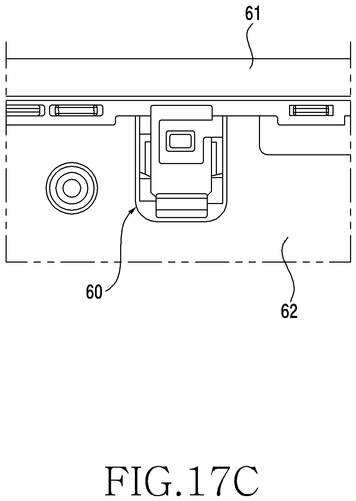

FIG. 16A is a plan view illustrating a state in which a microphone is mounted to a microphone coupling structure according to various embodiments of the disclosure. FIG. 16B is a cross-sectional view taken along the line B-B' of FIG. 12A. FIG. 16C is a cutaway perspective view illustrating a microphone coupling structure of an electronic device according to various embodiments of the disclosure. FIG. 17A is a perspective view illustrating a microphone storing portion constructed at a rear case outer part according to various embodiments of the disclosure. FIG. 17B is a perspective view illustrating an opening to be inserted to a microphone storing portion, which is constructed at a rear case inner part, according to various embodiments of the disclosure. FIG. 17C is a plan view illustrating a microphone coupling structure according to various embodiments of the disclosure.

Referring to FIG. 16A to FIG. 17C, in a microphone coupling structure 60 (e.g., the microphone coupling structure 30 of FIG. 5A) according to various embodiments, a microphone acoustic duct 610 and a microphone mounting portion 612 may be injection-molded integrally to a rear case outer part 61. The microphone acoustic duct 610 may be constructed at the rear case outer part 61, and the microphone mounting portion 612 may be molded to the rear case outer part 61 by being coupled integrally to the microphone acoustic duct 610. A rear case inner part 62 may have at least one or more openings 620 to be coupled with the microphone coupling structure 60.

The microphone acoustic duct 610 according to various embodiments may include one end 61a disposed to an exterior of the rear case outer part 61 and the other end 61b facing the microphone mounting portion 612. According to an embodiment, the microphone acoustic duct 610 may include a first sound passage 610a which extends substantially horizontally, and a second sound passage 610b which is spatially coupled with the first sound passage 610a and which extends substantially vertically.

The microphone mounting portion 612 according to various embodiments may include a seating portion 613 at an upper face, and a sealing member 615 may be seated at the seating portion. The sealing member 615 may seal between the microphone 40 and the microphone mounting portion 612. The sealing member 615 may further include a protrusion 615a for preventing a sound leakage.

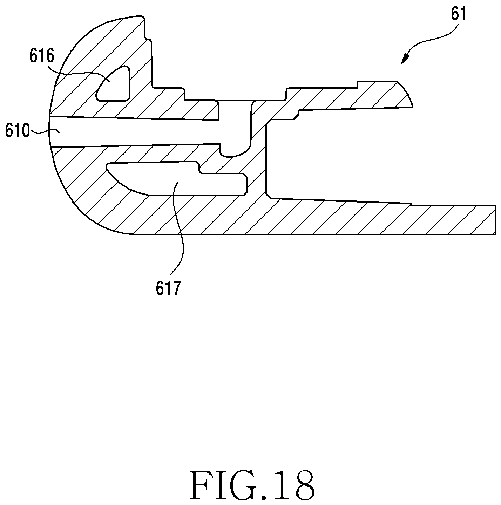

FIG. 18 is a cross-sectional view illustrating a rear case outer part according to various embodiments of the disclosure.

Referring to FIG. 18, in a rear case outer part 61 according to various embodiments, a core-out structure may be applied to minimize a wall-thickness deviation of an injection portion. For example, the rear case outer part 61 may have a first empty space 616 constructed by coring out an upper portion of a microphone acoustic duct 610, and may have a second empty space 617 constructed by coring out a lower portion of the microphone acoustic duct 610. The first and second spaces 616 and 617 may minimize the wall-thickness deviation of the rear case outer part 61 to prevent shrinkage of an exterior face of the rear case outer part 61. For example, the core-out process may be performed on the rear case outer part 61 when an injection manufacturing process is performed by using a mold.

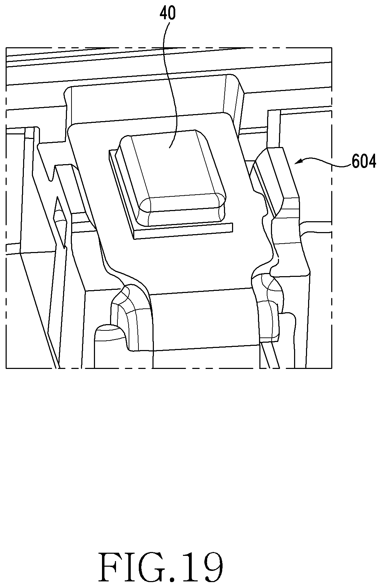

FIG. 19 is a perspective view illustrating a locking structure for preventing a mounted microphone from being lifted according to various embodiments of the disclosure.

Referring to FIG. 19, since a microphone locking structure 604 according to various embodiments has the same configuration as the microphone locking structure 504 of FIG. 14A, detailed descriptions on the microphone locking structure 604 will be omitted.

According to an embodiment of the disclosure, an electronic device (e.g., the electronic device 1000 of FIG. 1A) may include a body (e.g., the body 10 of FIG. 1A) including a first face (e.g., the first face 10a of FIG. 1A) which faces a first direction (e.g., the first direction ① of FIG. 1B), a second face (e.g., the second face 10b of FIG. 1B) which faces a second direction (e.g., the second direction ② of FIG. 1B) opposite to the first direction, and one or more side faces (e.g., the third face 10c of FIG. 1B) which face a third direction (e.g., the third direction ③ of FIG. 1B) perpendicular to each of the first and second directions, and a rear case (e.g., the rear case 20 of FIG. 1C) which is coupled along the one side faces and includes one or more microphone coupling structures (e.g., the microphone coupling structure 30 of FIG. 5A). The rear case may include a rear case outer part (e.g., the rear case outer part 21 of FIG. 5A) and a rear case inner part (e.g., the rear case inner part 22 of FIG. 5A) coupled to the rear case outer part through horizontal sliding. The microphone coupling structure may include a microphone acoustic duct (e.g., the microphone acoustic duct 31 of FIG. 5A) constructed at the rear case outer part, a microphone rubber mounting portion (e.g., the microphone rubber mounting portion 32 of FIG. 5A) constructed at the rear case inner part and inserted to the acoustic duct, and a microphone rubber (e.g., the microphone rubber 33 of FIG. 5A) assembled to the microphone rubber mounting portion and spatially coupled to the acoustic duct.

According to an embodiment of the disclosure, the microphone acoustic duct (e.g., the microphone acoustic duct 31 of FIG. 5A) may protrude towards the microphone rubber mounting portion (e.g., the rear case outer part 21 of FIG. 5A) in an inner face of the rear case outer part.

According to an embodiment of the disclosure, the microphone acoustic duct (e.g., the microphone acoustic duct 31 of FIG. 5A) may include one end (e.g., the one end 31a of FIG. 6B) disposed to an exterior of the rear case outer part (e.g., the rear case outer part 21 of FIG. 5A), and the other end (e.g., the other end 31b of FIG. 6B) closely in contact with the microphone rubber.

According to an embodiment of the disclosure, the microphone rubber mounting portion (e.g., the microphone rubber mounting portion 32 of FIG. 5A) may include a first opening (e.g., the first opening 321 of FIG. 7A) through which the microphone acoustic duct (e.g., the microphone acoustic duct 31 of FIG. 5A) penetrates and which is open in the third direction (e.g., the third direction ③ of FIG. 1B), and a second opening (e.g., the second opening 322 of FIG. 7A) to which the microphone rubber is inserted and which is open in the first direction (e.g., the first direction ① of FIG. 1B), and a plurality of side walls (e.g., the side walls 323 of FIG. 7A) which surround the first and second openings and which protrude in the first direction.

According to an embodiment of the disclosure, after the coupling of the rear case inner and outer parts, the microphone robber (e.g., the microphone rubber 33 of FIG. 5A) may be assembled in the microphone rubber mounting portion (e.g., the microphone rubber mounting portion 32 of FIG. 5A) in a vertically detachable manner, and may include a first sound passage (e.g., the first sound passage 331 of FIG. 8A) which is spatially coupled with the other end (e.g., the other end 31b of FIG. 6B) of the microphone acoustic duct (e.g., the microphone acoustic duct 31 of FIG. 6A) and which extends in the third direction, and a second sound passage (e.g., the second sound passage e332 of FIG. 8A) which is coupled with the first sound passage and which extends in the first direction to be spatially coupled with a microphone.

According to an embodiment of the disclosure, a first protrusion for preventing a sound leakage (e.g., the first protrusion 332 for preventing the sound leakage of FIG. 8A) may be further constructed at the microphone rubber (e.g., the microphone rubber 33 of FIG. 5A) to seal between the other end (e.g., the other end 31b of FIG. 6B) of the microphone acoustic duct and an end portion of the first sound passage (e.g., the first sound passage 331 of FIG. 8A) of the microphone rubber (e.g., the microphone rubber 33 of FIG. 5A).

According to an embodiment of the disclosure, the first protrusion for preventing the sound leakage (e.g., the first protrusion 332 for preventing the sound leakage of FIG. 8A) may have a ring shape and may be closely in contact with the other end (e.g., the other end 31b of FIG. 6B) of the microphone duct.

According to an embodiment of the disclosure, the microphone rubber (e.g., the microphone rubber 33 of FIG. 5A) may further include a seating portion (e.g., the seating portion 333 of FIG. 8A) to which the microphone (e.g., the microphone 40 of FIG. 5A) is mounted. The seating portion may be disposed to a periphery of the mounted microphone so that a second protrusion for preventing a sound leakage (e.g., the second protrusion 334 for preventing the sound leakage of FIG. 8A) is further constructed to seal the microphone.

According to an embodiment of the disclosure, the rear case outer part (e.g., the rear case outer part 21 of FIG. 5A) may further have a locking structure (e.g., the locking structure 210 of FIG. 9) constructed to prevent the microphone rubber (e.g., the microphone rubber 33 of FIG. 5A) mounted to the microphone robber mounting portion from being lifted. The locking structure may be constructed at an upper end of the rear case outer part in a shape which protrudes above at least part of the mounted microphone rubber (e.g., the microphone rubber 33 of FIG. 5A).

According to an embodiment of the disclosure, an electronic device (e.g., the electronic device 1000 of FIG. 1A) may include a body (e.g., the body 10 of FIG. 1A) including a first face (e.g., the first face 10a of FIG. 1A) which faces a first direction (e.g., the first direction ① of FIG. 1B), a second face (e.g., the second face 10b of FIG. 1B) which faces a second direction (e.g., the second direction ② of FIG. 1B) opposite to the first direction, and one or more side faces (e.g., the third face 10c of FIB. 1B) which face a third direction (e.g., the third direction ③ of FIG. 1B) perpendicular to each of the first and second directions, and a rear case (e.g., the rear case 20 of FIG. 1C) which is coupled along the one side face. The rear case may include a rear case outer part (e.g., the rear case outer part 51 of FIG. 12B) in which at least one or more microphone coupling structures (e.g., the microphone coupling structures 50 of FIG. 12B) are constructed, and a rear case inner part (e.g., the rear case inner part 52 of FIG. 12B) coupled to the rear case outer part through horizontal sliding. The microphone coupling structure may include a microphone acoustic duct (e.g., the microphone acoustic duct 510 of FIG. 12B) constructed at the rear case outer part, and a microphone mounting portion (e.g., the microphone mounting portion 512 of FIG. 13C) constructed at the rear case outer part so as to be coupled integrally to the microphone acoustic duct through a double injection process by using a microphone insert (e.g., the microphone insert 513 of FIG. 13B).

According to an embodiment of the disclosure, the microphone acoustic duct (e.g., the microphone acoustic duct 510 of FIG. 12B) may include one end disposed to an exterior of the rear case outer part (e.g., the rear case outer part 51 of FIG. 12B), and the other end facing the microphone disposed to the microphone mounting portion (e.g., the microphone mounting portion 512 of FIG. 13C).

According to an embodiment of the disclosure, the microphone acoustic duct (e.g., the microphone acoustic duct 510 of FIG. 12B) may include a first sound passage (e.g., the first sound passage 510a of FIG. 12B) which extends substantially horizontally from the rear case outer part (e.g., the rear case outer part 51 of FIG. 12B) and a second sound passage (e.g., the second sound passage 510b of FIG. 12B) which is spatially coupled with the first sound passage and which extends substantially vertically.

According to an embodiment of the disclosure, the microphone mounting portion (e.g., the microphone mounting portion 512 of FIG. 13C) may further have a sealing member (e.g., the sealing member 515 of FIG. 12B) disposed to seal between the microphone mounting portion and a microphone.

According to an embodiment of the disclosure, the sealing member (e.g., the sealing member 515 of FIG. 12B) may further have a protrusion constructed to prevent a sound leakage.

According to an embodiment of the disclosure, a locking structure (e.g., the locking structure 504 of FIG. 14A) may be further constructed to prevent a microphone mounted to the microphone mounting portion from being lifted. The locking structure may include a pair of locking holes (e.g., the locking holes 512a and 512b of FIG. 14B) which are constructed at one face of the microphone mounting portion, and a pair of locking protrusions (e.g., the locking protrusion 403 of FIG. 14C) which are constructed at both ends of a circuit board of the microphone in directions away from each other, and which are inserted to the pair of locking holes.

Various embodiments of the disclosure disclosed in the specification and the drawing are merely a specific example presented for clarity and are not intended to limit the scope of the embodiments of the disclosure. Therefore, in addition to the embodiments disclosed herein, various changes in forms and details made without departing from the technical concept of the various embodiments of the disclosure will be construed as being included in the scope of the various embodiments of the disclosure.

## Claims

1. An electronic device comprising:
a body comprising a first face which faces a first direction, a second face which faces a second direction opposite to the first direction, and one or more side faces which face a third direction perpendicular to each of the first and second directions; and
a rear case which is coupled along the one side faces and comprises one or more microphone coupling structures, wherein the rear case comprises:
a rear case outer part; and
a rear case inner part coupled to the rear case outer part through horizontal sliding,
wherein the microphone coupling structure comprises:
a microphone acoustic duct constructed at the rear case outer part;
a microphone rubber mounting portion constructed at the rear case inner part and inserted to the acoustic duct; and
a microphone rubber assembled to the microphone rubber mounting portion and spatially coupled to the acoustic duct.

2. The electronic device of claim 1, wherein the microphone acoustic duct protrudes towards the microphone rubber mounting portion in an inner face of the rear case outer part.

3. The electronic device of claim 1, wherein the microphone acoustic duct comprises:
one end disposed to an exterior of the rear case outer part; and
the other end closely in contact with the microphone rubber.

4. The electronic device of claim 1, wherein the microphone rubber mounting portion comprises:
a first opening through which the microphone acoustic duct penetrates and which is open in the third direction; and
a second opening to which the microphone rubber is inserted and which is open in the first direction; and
a plurality of side walls which surround the first and second openings and which protrude in the first direction.

5. The electronic device of claim 3, wherein after the coupling of the rear case inner and outer parts, the microphone rubber is assembled in the microphone rubber mounting portion in a vertically detachable manner, and comprises:
a first sound passage which is spatially coupled with the other end of the microphone acoustic duct and which extends in the third direction; and
a second sound passage which is coupled with the first sound passage and which extends in the first direction to be spatially coupled with a microphone.

6. The electronic device of claim 5, wherein a first protrusion for preventing a sound leakage is further constructed at the microphone rubber to seal between the other end of the microphone acoustic duct and an end portion of the first sound passage of the microphone rubber.

7. The electronic device of claim 6, wherein the first protrusion for preventing the sound leakage has a ring shape and is closely in contact with the other end of the microphone duct.

8. The electronic device of claim 6, wherein the microphone rubber further comprises a seating portion to which the microphone is mounted, and the seating portion is disposed to a periphery of the mounted microphone so that a second protrusion for preventing a sound leakage is further constructed to seal the microphone.

9. The electronic device of claim 1,
wherein the rear case outer part further has a locking structure constructed to prevent the microphone rubber mounted to the microphone robber mounting portion from being lifted, and
wherein the locking structure is constructed at an upper end of the rear case outer part in a shape which protrudes above at least part of the mounted microphone rubber.

10. An electronic device comprising:
a body comprising a first face which faces a first direction, a second face which faces a second direction opposite to the first direction, and one or more side faces which face a third direction perpendicular to each of the first and second directions; and
a rear case which is coupled along the one side face, wherein the rear case comprises:
a rear case outer part in which at least one or more microphone coupling structures are constructed; and
a rear case inner part coupled to the rear case outer part through horizontal sliding,
wherein the microphone coupling structure comprises:
a microphone acoustic duct constructed at the rear case outer part; and
a microphone mounting portion constructed at the rear case outer part so as to be coupled integrally to the microphone acoustic duct through a double injection process by using a microphone insert.

11. The electronic device of claim 10, wherein the microphone acoustic duct comprises:
one end disposed to an exterior of the rear case outer part; and
the other end facing the microphone disposed to the microphone mounting portion.

12. The electronic device of claim 10, wherein the microphone acoustic duct comprises:
a first sound passage which extends substantially horizontally from the rear case outer part; and
a second sound passage which is spatially coupled with the first sound passage and which extends substantially vertically.

13. The electronic device of claim 10, wherein the microphone mounting portion further has a sealing member disposed to seal between the microphone mounting portion and a microphone.

14. The electronic device of claim 13, wherein the sealing member further has a protrusion constructed to prevent a sound leakage.

15. The electronic device of claim 10, wherein a locking structure is further constructed to prevent a microphone mounted to the microphone mounting portion from being lifted, wherein the locking structure comprises:
a pair of locking holes which are constructed at one face of the microphone mounting portion; and
a pair of locking protrusions which are constructed at both ends of a circuit board of the microphone in directions away from each other, and which are inserted to the pair of locking holes.
